# FASCICULE DE BREVET EUROPEEN

(11) **EP 3 413 064 B1**
(45) Date de publication et mention de la délivrance du brevet: **10.09.2025**
(21) Numéro de dépôt: 18175822.8
(22) Date de dépôt: 04.06.2018
(51) Int. Cl.: G01R 31/50

(54) **EQUIPEMENT ELECTRIQUE DESTINE A ETRE RELIE A UN TACHYMETRE**
ELEKTRISCHE AUSRÜSTUNG ZUM ANSCHLUSS AN EINEN TACHOMETER
ELECTRICAL DEVICE TO BE CONNECTED TO A TACHOMETER

(30) Priorité: 07.06.2017 FR 1755062
(43) Date de publication de la demande: 12.12.2018
(73) Titulaire: Safran Landing Systems, 78140 Vélizy-Villacoublay (FR)
(72) Inventeur: SANCHIS, Ghislain, 78140 VELIZY-VILLACOUBLAY (FR)
(74) Mandataire: Cabinet Boettcher

(56) Documents cités:
- EP-A1- 0 764 829
- WO-A1-2015/036445
- WO-A1-2016/146918
- FR-A1- 2 328 967
- FR-A1- 2 621 166
- FR-A1- 2 701 176
- FR-A1- 3 023 071
- JP-A- S58 113 767
- US-A- 4 805 447
- US-A- 5 422 568
- US-A1- 2004 189 323
- US-A1- 2016 003 885

## Description

L'invention concerne le domaine des équipements électriques de type calculateur ou concentrateur de données, destinés à être reliés à des tachymètres.

### ARRIERE PLAN DE L'INVENTION

Un tachymètre, destiné à mesurer une vitesse de rotation d'une roue d'un atterrisseur d'un aéronef, comporte classiquement un rotor solidaire en rotation de la roue, un stator et un capteur de vitesse de rotation. Le capteur de vitesse de rotation comprend un bobinage positionné sur le stator.

Le bobinage est relié via un câble à un calculateur (ou à tout autre équipement électrique, par exemple à un concentrateur de données). Le calculateur acquiert ainsi un signal électrique de mesure dont une tension et/ou une fréquence sont représentatives de la vitesse de rotation de la roue.

Généralement, une pluralité de câbles provenant d'une pluralité de tachymètres sont regroupés dans un harnais qui chemine depuis l'atterrisseur jusqu'à l'intérieur du fuselage de l'aéronef où est positionné le calculateur.

Or, il est possible que l'un des pneumatiques des roues de l'atterrisseur éclate. Des débris de pneumatique sont alors projetés et peuvent endommager le harnais et sectionner l'un des câbles.

Il convient alors de détecter la perte du tachymètre relié au câble sectionné. On note qu'une tension nulle du signal électrique de mesure peut correspondre à une vitesse de rotation nulle et donc à une mesure de vitesse de rotation « normale » et correctement mesurée.

On note aussi qu'il est possible que l'une des roues, qui est en train de patiner, présente une vitesse de rotation nulle alors la vitesse de rotation des autres roues est non nulle.

La simple détection d'une tension nulle, même associée à une comparaison avec les vitesses de rotation d'autres roues, ne suffit donc pas à détecter un câble sectionné.

Il a été envisagé, pour chaque tachymètre, de redonder le capteur de vitesse de rotation. Cette redondance impose de doubler le nombre d'entrées du calculateur dédiées à la mesure de vitesse de rotation des roues, et ajoute une masse et un encombrement supplémentaires au niveau de chaque tachymètre. Cette redondance implique aussi d'utiliser deux câbles au lieu d'un seul entre le tachymètre et le calculateur.

Il a aussi été envisagé de redonder uniquement le câble qui relie le tachymètre au calculateur. Cette redondance ajoute aussi une masse supplémentaire et créé des boucles dans le circuit électrique formé par les câbles et le calculateur, ce qui est problématique pour la conformité aux exigences de compatibilité électromagnétique.

On note que, dans les deux solutions qui viennent d'être décrites, la perte des deux câbles reliant le tachymètre au calculateur n'est pas détectée.

Il a enfin été envisagé de tester régulièrement la continuité du câble et du bobinage en injectant un faible signal dans le câble et dans le bobinage. Ceci implique cependant de désactiver régulièrement l'acquisition du signal électrique de mesure, et donc de la vitesse de rotation de la roue, ce qui n'est pas acceptable dans un système de freinage qui met en œuvre une fonction d'anti-patinage. Le document EP 0 764 829 A1 divulgue une approche de détection d'une déconnexion d'un fil de mesure dans un dispositif tachymètre.

### OBJET DE L'INVENTION

L'invention a pour objet de détecter une rupture d'un câble reliant un tachymètre à un équipement électrique de manière simple, peu encombrante et sans désactiver la mesure de la vitesse de rotation de la roue.

### RESUME DE L'INVENTION

En vue de la réalisation de ce but, on propose un équipement électrique de type calculateur ou concentrateur de données, destiné à être relié à un tachymètre via un câble comprenant un fil de mesure et un fil de test, l'équipement électrique comprenant une entrée de mesure à laquelle peut être connecté le fil de mesure et une entrée de test à laquelle peut être connecté le fil de test, des composants d'acquisition de mesure reliés à l'entrée de mesure et agencés pour acquérir un signal électrique de mesure présent sur le fil de mesure et produit par le tachymètre, des composants d'acquisition de test reliés à l'entrée de test et agencés pour détecter si le fil de test est en circuit ouvert ou non, et des composants de traitement agencés pour détecter une rupture du fil de mesure si le fil de test est en circuit ouvert.

On détecte donc une rupture du fil de mesure en détectant un circuit ouvert du fil de test. Cette solution est simple à mettre en œuvre et peu encombrante, puisqu'elle nécessite uniquement l'ajout du fil de test dans le câble qui comprend le fil de mesure relié au tachymètre. Cette solution ne nécessite pas de désactiver l'acquisition du signal électrique de mesure, puisque le fil de test, qui permet la détection de la rupture du fil de mesure, est distinct du fil de mesure.

On propose de plus un système comprenant un tachymètre, un câble comprenant un fil de mesure et un fil de test, et un équipement électrique tel que celui qui vient d'être décrit, le câble comprenant une première extrémité connectée au tachymètre et une deuxième extrémité connectée à l'équipement électrique.

L'invention sera mieux comprise à la lumière de la description qui suit de modes de mise en œuvre particuliers non limitatifs de l'invention.

### BREVE DESCRIPTION DES DESSINS

Il sera fait référence aux dessins annexés, parmi lesquels :
- la figure 1 représente un équipement électrique selon un premier mode de réalisation de l'invention, un câble et un tachymètre ;
- la figure 2 représente des composants d'acquisition de test de l'équipement électrique selon le premier mode de réalisation de l'invention ;
- la figure 3 représente des composants d'acquisition de test d'un équipement électrique selon un deuxième mode de réalisation de l'invention ;
- la figure 4 représente un équipement électrique selon un troisième mode de réalisation de l'invention, un câble et un tachymètre ;
- la figure 5 représente un équipement électrique selon un quatrième mode de réalisation de l'invention, un câble et un tachymètre.

### DESCRIPTION DETAILLEE DE L'INVENTION

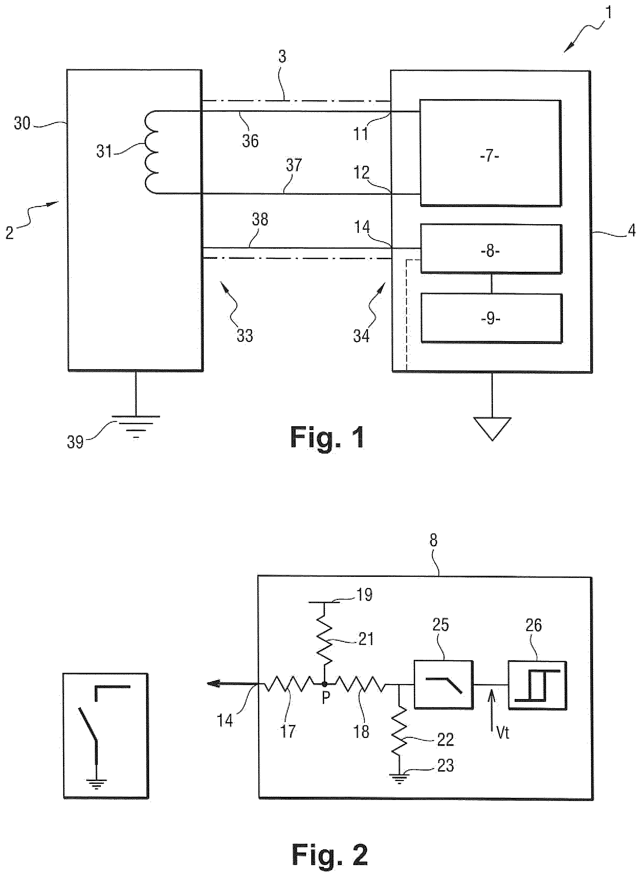

En référence à la figure 1, l'équipement électrique selon un premier mode de réalisation de l'invention est ici un calculateur 1. Le calculateur 1 est relié à un tachymètre 2 via un câble 3.

Le calculateur 1 est situé dans une soute d'un aéronef.

Le calculateur 1 comporte un carter 4 dans lequel sont intégrés des composants d'acquisition de mesure 7, des composants d'acquisition de test 8 et des composants de traitement 9.

Le calculateur 1 comporte une première entrée de mesure 11 et une deuxième entrée de mesure 12. La première entrée de mesure 11 et la deuxième entrée de mesure 12 sont reliées aux composants d'acquisition de mesure 7.

Le calculateur 1 comporte aussi une entrée de test 14. L'entrée de test 14 est une entrée discrète. L'entrée de test 14 est reliée aux composants d'acquisition de test 8.

Les composants d'acquisition de test 8 sont visibles sur la figure 2. Les composants d'acquisition de test 8 sont ici des composants d'acquisition d'un signal discret.

Les composants d'acquisition de test 8 comportent une résistance 17 et une résistance 18 reliées à l'entrée de test 14, une source de tension de référence 19 connectée via une résistance 21 à un point P situé entre la résistance 17 et la résistance 18, et une résistance 22 connectée entre la résistance 18 et une masse électrique 23 du calculateur 1. Les composants d'acquisition de test 8 comportent en outre un filtre passe-bas 25 et un comparateur à hystérésis 26. Une entrée du filtre passe-bas 25 est reliée à la résistance 18 et à la résistance 22. Une sortie du filtre passe-bas 25 est reliée à une entrée du comparateur à hystérésis 26.

La masse électrique 23 est reliée au carter 4 du calculateur 1.

Le tachymètre 2 est destiné à mesurer la vitesse de rotation d'une roue d'un atterrisseur de l'aéronef. Le tachymètre 2 comporte un carter 30 dans lequel est intégré un capteur de vitesse de rotation. Le capteur de vitesse de rotation comporte un rotor et un stator qui comprend un enroulement 31.

Le câble 3 est ici positionné, sur une partie de sa longueur, dans un harnais qui regroupe une pluralité de câbles similaires reliés à des tachymètres. Le harnais chemine depuis l'atterrisseur vers la soute de l'aéronef.

Le câble 3 comporte une première extrémité 33 et une deuxième extrémité 34. La première extrémité 33 est connectée au tachymètre 2. La deuxième extrémité 34 est connectée au calculateur 1.

Le câble 3 comprend un premier fil de mesure 36, un deuxième fil de mesure 37 et un fil de test 38. Le premier fil de mesure 36, le deuxième fil de mesure 37 et le fil de test 38 sont torsadés, c'est-à-dire qu'ils sont enroulés en hélice les uns autour des autres.

Au niveau de la première extrémité 33 du câble 3, le premier fil de mesure 36 est relié à une première borne de l'enroulement 31 du stator. Le deuxième fil de mesure 37 est relié à une deuxième borne de l'enroulement 31 du stator. Le fil de test 38 est relié quant à lui à une masse 39 du tachymètre 2 via un blindage du harnais ou du câble 3, ou bien via une masse mécanique du tachymètre 2 si le carter 30 du tachymètre 2 est référencé à la masse.

Au niveau de la deuxième extrémité 34 du câble 3, le premier fil de mesure 36 est relié à la première entrée de mesure 11 du calculateur 1, le deuxième fil de mesure 37 est relié à la deuxième entrée de mesure 12, et le fil de test 38 est relié à l'entrée de test 14.

Les composants d'acquisition de mesure 7 du calculateur 1 acquièrent un signal électrique de mesure dont une tension et/ou une fréquence sont représentatives de la vitesse de rotation de la roue.

Les composants d'acquisition de test 8, quant à eux, comparent une tension de test Vt en entrée du comparateur à hystérésis 26 avec un seuil de détection, en l'occurrence un seuil de tension prédéterminé. La tension de test Vt est représentative de l'impédance appliquée sur l'entrée de test 14.

Si la tension de test Vt est inférieure au seuil de tension prédéterminé, les composants d'acquisition de test 8 détectent qu'un signal discret de mise à la masse est appliqué sur l'entrée de test 14. La mise à la masse correspond à la connexion du fil de test 38 à la masse 39 du tachymètre 2 au niveau de la première extrémité 33 du câble 3.

Les composants de traitement 9 détectent alors une continuité du fil de test 38, et donc que le fil de test 38 n'est pas rompu. Les composants de traitement 9 ne détectent donc pas de rupture du premier fil de mesure 36 ou du deuxième fil de mesure 37. En effet, du fait de la proximité entre le fil de test 38 et le premier fil de mesure 36 et le deuxième fil de mesure 37, une rupture du fil de test 38, due par exemple à une explosion d'un pneumatique, aurait très probablement été accompagnée d'une rupture du premier fil de mesure 36 ou du deuxième fil de mesure 37.

Si la tension de test Vt est supérieure ou égale au seuil de tension prédéterminé, les composants d'acquisition de test 8 détectent qu'un signal discret de circuit ouvert est appliqué sur l'entrée de test 14. Le circuit ouvert correspond à un circuit ouvert du fil de test 38.

Les composants de traitement 9 détectent alors une rupture du fil de test 38, et donc une rupture du premier fil de mesure 36 et/ou du deuxième fil de mesure 37. Les composants de traitement 9 invalident des mesures de vitesse de rotation issues du signal électrique de mesure, désactivent le tachymètre 2 et génèrent un message de panne.

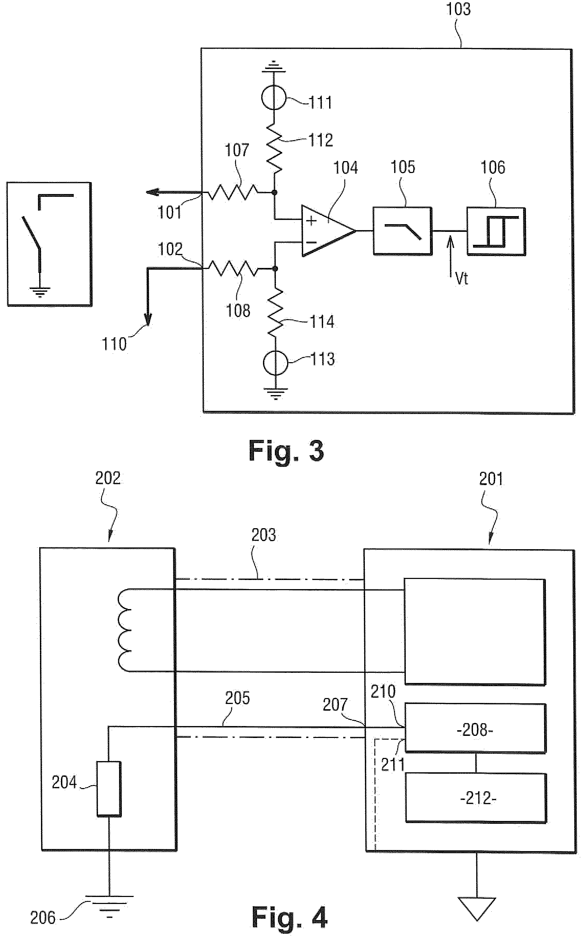

En référence à la figure 3, l'équipement électrique selon un deuxième mode de réalisation de l'invention est à nouveau un calculateur. Le calculateur est relié à un tachymètre via un câble. Le tachymètre et le câble sont semblables à ceux qui viennent d'être décrits.

Le calculateur comporte cette fois une première entrée de test 101 et une deuxième entrée de test 102. La première entrée de test 101 et la deuxième entrée de test 102 sont toutes deux des entrées discrètes. Le calculateur comporte des composants d'acquisition de test 103. Les composants d'acquisition de test 103 sont à nouveau des composants d'acquisition d'un signal discret.

Les composants d'acquisition de test 103 comportent un amplificateur opérationnel 104, un filtre passe-bas 105 et un comparateur à hystérésis 106.

Une entrée non inverseuse de l'amplificateur opérationnel 104 est reliée à la première entrée de test 101 via une résistance 107. Une entrée inverseuse de l'amplificateur opérationnel 104 est reliée à la deuxième entrée de test 102 via une résistance 108.

Le fil de test est relié à la première entrée de test 101.

La deuxième entrée de test 102 est reliée à une masse électrique 110 du calculateur, par exemple via le carter du calculateur ou via le blindage du harnais ou du câble.

Une première source de courant de référence 111 est reliée à l'entrée non inverseuse via une résistance 112. Une deuxième source de courant de référence 113 est reliée à l'entrée inverseuse via une résistance 114.

Une sortie de l'amplificateur opérationnel 104 est reliée à une entrée du filtre passe-bas 105. Une sortie du filtre passe-bas 105 est reliée à une entrée du comparateur à hystérésis 106.

A nouveau, les composants d'acquisition de test 103 comparent une tension de test Vt en entrée du comparateur à hystérésis 106 avec un seuil de tension prédéterminé. La tension de test Vt est représentative de l'impédance appliquée entre la première entrée de test 101 et la deuxième entrée de test 102.

Si la tension de test Vt est inférieure au seuil de tension prédéterminé, les composants d'acquisition de test 103 détectent qu'un signal discret de mise à la masse est appliqué sur la première entrée de test 101.

Les composants de traitement détectent alors une continuité du fil de test, et donc que le fil de test n'est pas rompu. Les composants de traitement ne détectent donc pas de rupture du premier fil de mesure ou du deuxième fil de mesure.

Si la tension de test Vt est supérieure au seuil de tension prédéterminé, les composants d'acquisition de test 103 détectent qu'un signal discret de circuit ouvert est appliqué sur la première entrée de test 101.

Les composants de traitement détectent alors une rupture du fil de test, et donc une rupture du premier fil de mesure et/ou du deuxième fil de mesure. Les composants de traitement invalident des mesures de vitesse de rotation issues du signal électrique de mesure, désactivent le tachymètre et génèrent un message de panne.

En référence à la figure 4, l'équipement électrique selon un troisième mode de réalisation de l'invention est un calculateur 201. Le calculateur 201 est relié à un tachymètre 202 via un câble 203.

Le tachymètre 202 comporte un circuit électrique sur lequel est montée une résistance 204. Le fil de test 205 est relié à la masse 206 du tachymètre 202 via la résistance 204.

Le calculateur 201 comporte une entrée de test 207 reliée au fil de test 205. Les composants d'acquisition de test 208 sont cette fois des composants de mesure de résistance.

Les composants d'acquisition de test 208 comportent une première entrée 210 reliée à l'entrée de test 207 du calculateur 201, et une deuxième entrée 211 reliée à une masse électrique du calculateur 201.

Les composants d'acquisition de test 208 mesurent une résistance de test entre la première entrée 210 et la deuxième entrée 211, et donc entre l'entrée de test 207 et la masse électrique du calculateur 201.

Si la résistance de test est inférieure à un seuil de résistance prédéterminé, les composants d'acquisition de test 208 ne détectent pas que le fil de test 205 est en circuit ouvert. Les composants de traitement 212 détectent que le fil de test 205 n'est pas rompu.

Si la résistance de test est supérieure ou égale à un seuil de résistance prédéterminé, les composants d'acquisition de test 208 détectent que le fil de test 205 est en circuit ouvert.

Les composants de traitement 212 détectent alors une rupture du fil de test 205, et donc une rupture du premier fil de mesure et/ou du deuxième fil de mesure. Les composants de traitement 212 invalident des mesures de vitesse de rotation issues du signal électrique de mesure, désactivent le tachymètre et génèrent un message de panne.

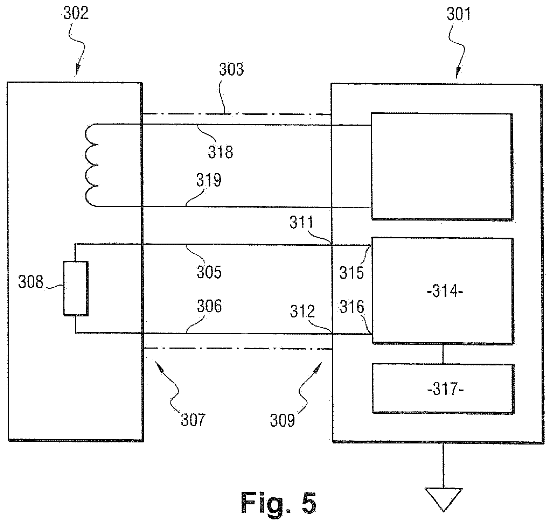

En référence à la figure 5, l'équipement électrique selon un quatrième mode de réalisation de l'invention est un calculateur 301. Le calculateur 301 est relié à un tachymètre 302 via un câble 303.

Dans le quatrième mode de réalisation de l'invention, le câble 303 comporte cette fois un premier fil de test 305 et un deuxième fil de test 306.

Le premier fil de test 305 est relié, au niveau d'une première extrémité 307 du câble 303, à une première borne d'une résistance 308 du tachymètre 302. Le deuxième fil de test 306 est relié, au niveau de la première extrémité 307 du câble 303, à une deuxième borne de la résistance 308.

Le premier fil de test 305 est relié, au niveau d'une deuxième extrémité 309 du câble 303, à une première entrée de test 311 du calculateur 301. Le deuxième fil de test 306 est relié, au niveau de la deuxième extrémité 309 du câble 303, à une deuxième entrée de test 312 du calculateur 301.

Les composants d'acquisition de test 314 comportent une première entrée 315 reliée à la première entrée de test 311 du calculateur 301, et une deuxième entrée 316 reliée à la deuxième entrée de test 312 du calculateur 301.

Les composants d'acquisition de test 314 sont à nouveau des composants de mesure de résistance.

Les composants d'acquisition de test 314 mesurent une résistance de test entre la première entrée 315 et la deuxième entrée 316, et donc entre la première entrée de test 311 et la deuxième entrée de test 312 du calculateur 301.

Si la résistance de test est comprise dans une plage valide de valeurs de résistance, les composants de traitement 317 détectent que le premier fil de test 305 et le deuxième fil de test 306 ne sont pas rompus.

Si la résistance de test n'est pas comprise dans la plage valide de valeurs de résistance, les composants de traitement 317 détectent que le premier fil de test 305 et/ou le deuxième fil de test 306 sont rompus.

Les composants de traitement 317 détectent alors une rupture du premier fil de mesure 318 et/ou du deuxième fil de mesure 319. Les composants de traitement 317 invalident des mesures de vitesse de rotation issues du signal électrique de mesure, désactivent le tachymètre et génèrent un message de panne.

Bien entendu, l'invention n'est pas limitée aux modes de réalisation décrits mais englobe toute variante entrant dans le champ de l'invention telle que définie par les revendications.

Bien que l'équipement électrique décrit ici soit un calculateur, cet équipement électrique pourrait être un équipement différent, par exemple un concentrateur de données.

## Revendications

1. Equipement électrique de type calculateur ou concentrateur de données, destiné à être relié à un tachymètre (2 ; 202 ; 302) via un câble (3 ; 203 ; 303) comprenant un fil de mesure (36, 37 ; 318, 319) et un fil de test (38 ; 205 ; 305, 306), l'équipement électrique comprenant une entrée de mesure (11, 12) à laquelle peut être connecté le fil de mesure et une entrée de test (14 ; 101, 102 ; 207 ; 311, 312) à laquelle peut être connecté le fil de test, des composants d'acquisition de mesure (7) reliés à l'entrée de mesure et agencés pour acquérir un signal électrique de mesure présent sur le fil de mesure et produit par le tachymètre, des composants d'acquisition de test (8 ; 103 ; 208 ; 314) reliés à l'entrée de test et agencés pour détecter si le fil de test est en circuit ouvert ou non, et des composants de traitement (9 ; 212 ; 317) agencés pour détecter une rupture du fil de mesure si le fil de test est en circuit ouvert.

2. Equipement électrique selon la revendication 1, dans lequel l'entrée de test (14 ; 101, 102) est une entrée discrète, et dans lequel les composants d'acquisition de test (8 ; 103) sont agencés pour détecter un signal discret de circuit ouvert ou un signal discret de mise à la masse.

3. Equipement électrique selon la revendication 2, l'équipement électrique comprenant une première entrée de test (101) et une deuxième entrée de test (102), la première entrée de test étant destinée à être connectée au fil de test et la deuxième entrée de test étant reliée à une masse électrique de l'équipement électrique.

4. Equipement électrique selon la revendication 1, dans lequel les composants d'acquisition de test sont agencés pour mesurer une résistance de test.

5. Equipement électrique selon la revendication 4, dans lequel la résistance de test est une résistance entre l'entrée de test (207) et une masse électrique de l'équipement électrique.

6. Equipement électrique selon la revendication 4, l'équipement électrique comprenant une première entrée de test (311) et une deuxième entrée de test (312), la résistance de test étant une résistance entre la première entrée de test (311) et la deuxième entrée de test (312).

7. Système comprenant un tachymètre, un câble comprenant un fil de mesure et un fil de test, et un équipement électrique selon l'une des revendications précédentes, le câble comprenant une première extrémité (33) connectée au tachymètre et une deuxième extrémité (34) connectée à l'équipement électrique.

8. Système selon la revendication 7, dans lequel le fil de mesure et le fil de test sont torsadés.

9. Système selon la revendication 7, dans lequel le fil de test est relié à une masse du tachymètre au niveau de la première extrémité du câble.

10. Système selon la revendication 7, dans lequel le tachymètre comporte un circuit électrique sur lequel est montée une résistance (204), et dans lequel le fil de test (205) est relié à une masse du tachymètre via la résistance.

11. Système selon la revendication 7, dans lequel le câble comprend deux fils de test (305, 306), dans lequel le tachymètre comporte un circuit électrique sur lequel est montée une résistance (308), et dans lequel chaque fil de test est relié à une borne distincte de la résistance.

## Patentansprüche

1. Elektrisches Gerät vom Typ Rechner oder Datenkonzentrator, welches dazu bestimmt ist, über ein Kabel (3; 203; 303), das einen Messdraht (36, 37; 318, 319) und einen Testdraht (38; 205; 305, 306) umfasst, an einen Tachometer (2; 202; 302) angeschlossen zu werden, wobei das elektrische Gerät umfasst: einen Messeingang (11, 12), an welchen der Messdraht angeschlossen werden kann, und einen Testeingang (14; 101, 102; 207 ; 311, 312), an welchen der Testdraht angeschlossen werden kann, Messungserfassungskomponenten (7), die mit dem Messeingang verbunden und derart ausgelegt sind, dass sie ein an dem Messdraht anliegendes und von dem Tachometer erzeugtes elektrisches Messsignal erfassen, Testerfassungskomponenten (8 ; 103; 208; 314), die mit dem Testeingang verbunden und dafür ausgelegt sind, zu erkennen, ob der Testdraht einen offenen Stromkreis aufweist oder nicht, und Verarbeitungskomponenten (9; 212; 317), die dafür ausgelegt sind, einen Bruch des Messdrahts zu erkennen, wenn der Testdraht einen offenen Stromkreis aufweist.

2. Elektrisches Gerät nach Anspruch 1, wobei es sich bei dem Testeingang (14 ; 101, 102) um einen diskreten Eingang handelt, und wobei die Testerfassungskomponenten (8; 103) dafür ausgelegt sind, ein diskretes Signal für einen offenen Stromkreis oder ein diskretes Erdungssignal zu erkennen.

3. Elektrisches Gerät nach Anspruch 2, wobei das elektrische Gerät einen ersten Testeingang (101) und einen zweiten Testeingang (102) umfasst, wobei der erste Testeingang dazu bestimmt ist, an den Testdraht angeschlossen zu werden und wobei der zweite Testeingang mit einer elektrischen Masse des elektrischen Geräts verbunden ist.

4. Elektrisches Gerät nach Anspruch 1, wobei die Testerfassungskomponenten dafür ausgelegt sind, einen Testwiderstand zu messen.

5. Elektrisches Gerät nach Anspruch 4, wobei es sich bei dem Testwiderstand um einen Widerstand zwischen dem Testeingang (207) und einer elektrischen Masse des elektrischen Geräts handelt.

6. Elektrisches Gerät nach Anspruch 4, wobei das elektrische Gerät einen ersten Testeingang (311) und einen zweiten Testeingang (312) umfasst, wobei es sich bei dem Testwiderstand um einen Widerstand zwischen dem ersten Testeingang (311) und dem zweiten Testeingang (312) handelt.

7. System, umfassend einen Tachometer, ein Kabel mit einem Messdraht und einem Testdraht, sowie ein elektrisches Gerät nach einem der vorhergehenden Ansprüche, wobei das Kabel ein an den Tachometer angeschlossenes erstes Ende (33) und ein an das elektrische Gerät angeschlossenes zweites Ende (34) umfasst.

8. System nach Anspruch 7, wobei der Messdraht und der Testdraht verdrillt sind.

9. System nach Anspruch 7, wobei der Testdraht im Bereich des ersten Endes des Kabels mit einer Masse des Tachometers verbunden ist.

10. System nach Anspruch 7, wobei der Tachometer einen Stromkreis enthält, in welchem ein Widerstand (204) geschaltet ist, und wobei der Testdraht (205) über den Widerstand mit einer Masse des Tachometers verbunden ist.

11. System nach Anspruch 7, wobei das Kabel zwei Testdrähte (305, 306) umfasst, wobei der Tachometer einen Stromkreis enthält, in welchem ein Widerstand (308) geschaltet ist, und wobei jeder Testdraht mit einem separaten Anschluss des Widerstands verbunden ist.

## Claims

1. Electrical equipment of the type comprising calculation means or a data concentrator for connecting to a tachometer (2; 202; 302) via a cable (3; 203; 303) that comprises a measurement wire (36, 37; 318, 319) and a test wire (38; 205; 305, 306), the electrical equipment having a measurement input (11, 12) to which the measurement wire can be connected and a test input (14; 101, 102; 207; 311, 312) to which the test wire can be connected, measurement acquisition components (7) connected to the measurement input and arranged to acquire an electrical measurement signal present on the measurement wire and produced by the tachometer, test acquisition components (8; 103; 208; 314) connected to the test input and arranged to detect whether the test wire is or is not open-circuit, and processor components (9; 212; 317) arranged to detect a break of the measurement wire if the test wire is open-circuit.

2. Electrical equipment according to claim 1, wherein the test input (14; 101, 102) is a discrete input, and wherein the test acquisition components (8; 103) are arranged to detect a discrete open-circuit signal or a discrete ground signal.

3. Electrical equipment according to claim 2, the electrical equipment including a first test input (101) and a second test input (102), the first test input being for connecting to the test wire and the second test input being connected to electrical ground of the electrical equipment.

4. Electrical equipment according to claim 1, wherein the test acquisition components are arranged to measure a test resistance.

5. Electrical equipment according to claim 4, wherein the test resistance is a resistance between the test input (207) and electrical ground of the electrical equipment.

6. Electrical equipment according to claim 4, wherein the electrical equipment includes a first test input (311) and a second test input (312), the test resistance being a resistance between the first test input (311) and the second test input (312).

7. A system comprising a tachometer, a cable including a measurement wire and a test wire, and electrical equipment according to any preceding claim, the cable having a first end (33) connected to the tachometer and a second end (34) connected to the electrical equipment.

8. A system according to claim 7, wherein the measurement wire and the test wire are twisted together.

9. A system according to claim 7, wherein the test wire is connected to tachometer ground at the first end of the cable.

10. A system according to claim 7, wherein the tachometer includes an electric circuit having a resistor (204) connected therein, and wherein the test wire (205) is connected to tachometer ground via the resistor.

11. A system according to claim 7, wherein the cable has two test wires (305, 306), wherein the tachometer has an electrical circuit having a resistor (308) connected therein, and wherein each test wire is connected to a distinct terminal of the resistor.
